Europäisches Patentamt

European Patent Office

Office européen des brevets

(11) Publication number: **0 058 645**
**B1**

# EUROPEAN PATENT SPECIFICATION

(45) Date of publication of patent specification: **04.06.86**

(21) Application number: **82830027.7**

(22) Date of filing: **08.02.82**

(51) Int. Cl.⁴: **G 01 J 5/28, H 01 L 31/02,**
**F 17 C 13/08, H 01 B 17/30**

(54) Infrared radiation detector device.

(30) Priority: **09.02.81 IT 4775381**

(43) Date of publication of application:
**25.08.82 Bulletin 82/34**

(45) Publication of the grant of the patent:
**04.06.86 Bulletin 86/23**

(84) Designated Contracting States:
**DE FR GB NL SE**

(56) References cited:
**US-A-3 719 990**
**US-A-3 851 173**
**US-A-4 059 764**
**US-A-4 118 947**
**US-A-4 206 354**

(73) Proprietor: **SELENIA INDUSTRIE
ELETTRONICHE ASSOCIATE S.p.A.
Via Tiburtina, KM 12.400
I-00131 Roma (IT)**

(72) Inventor: **Diedrich, Heinz Karl
Via G. Leopardi n. 51
I-00011 Bagni di Tivoli (Rome) (IT)**
Inventor: **Greco, Giovanni
Via Monte Senario n. 41
I-00141 Rome (IT)**
Inventor: **Fanti, Domenico
Via A. Scalpelli n. 1
I-00019 Tivoli (Rome) (IT)**

(74) Representative: **Gustorf, Gerhard, Dipl.-Ing.
Mühlenstrasse 1
D-8300 Landshut (DE)**

EP 0 058 645 B1

Courier Press, Leamington Spa, England.

# Description

The invention concerns a device as defined in the precharacterising portion of Claim 1. Such a device is known from US—A—3719990.

Present-day systems for the detection of infrared radiation in the medium or far infrared regions and in particular, systems for thermal imaging or for passive surveillance in the infrared, require infrared detectors with an elevated number of sensitive elements with sensibility performances (detectivities) near the theoretical limit, which require operative temperature conditions of typically from 70° Kelvin to 190° Kelvin.

An illustrative example (example 1) is an infrared system for thermal imagery (FLIR) for military applications featuring a number of 180 sensitive elements in linear configuration.

The cooling means is a 1 watt cryogenerator of closed-cycle type.

Another illustrative example (example 2) is a compact, hand-portable thermal viewer for military and industrial applications, featured by a number of about 50 sensitive elements in bidimensional configuration for serial-parallel scanning, and by an open-cycle Joule Thompson mini-cooler with less than 100 mwatt cooling power.

Whereas the examples 1 and 2 stand for a class of many infrared passive systems which have already reached an industrial production level, there is a world-wide effort to further improve overall system performances to satisfy requests for new applications and to reduce system production costs.

An essential part of this activity is focalized on the infrared detector which is the centre component of any infrared passive system.

The following examples should give an indication for some of the various lines directed to future systems.

1) Multielement detectors operating at temperatures which can be achieved by multistage thermoelectric (Peltier) coolers (example 3).

The solid-state type cold generator is completely integrated with the optoelectronic converter component resulting thus in an extremely small, compact, thermally self-sufficient detector. The very low electro-thermal conversion efficiency requires an extremely low thermal power consumption and hence, an extremely high thermal decoupling between the on focal plane, cooled sensor and the detector ambient, i.e. the walls of the detector embodiment and the vacuum multi-feed-through structure.

2) Multielement detectors for applications in missiles of short and medium range which are equipped with infrared imaging heads (example 4). Because of the limited missile overall dimensions together with severe operative conditions, a particularly small and rugged detector is mandatory with a diameter which is essentially limited by the vacuum feed through package density.

3) Multielement detector (example 5) for applications as sketched under example 1, featuring a linear or bidimensional photosensitive component integrated on focal plane with part of the electronic signal processing circuitry in hybrid or monolithic version, and with the detector suited to a new generation of very small size, low thermal power closed-cycle cryogenerators.

The examples 3 thru 5 indicate the trends in infrared detectors namely increasing integration and complexity of the photosensitive semiconductor component in a similar way as it is typical for conventional semiconductor devices, along with miniaturization of the vacuum embodiment component and lowering of its thermal power losses.

Under these aspects, the feed-through component of the detector device is of particularly problematic nature. Many technological solutions to this have been proposed and several of them have been applied for constructing reliable, high vacuum-tight feed-throughs for multielement infrared detectors. Amongst those, there is a particular version derived from the patents IT—A—49632-A/76, US—A—4.118.947, GB—A—1.537.187 and a ceramic/metal/ceramic overlay structure.

On this particular version we have performed an extensive technological study the results of which have led to the device according to the invention defined in Claim 1, which will be schematically described in the following and for which an illustrative concrete example will be given, aiming to demonstrate the advantages which this detector configuration presents. An important advantage of this configuration is in production cost savings. Due to the variety of detector-to-system inferfaces in the prior art and the complexity of combining the very different technological fields involved, detector costs are still relatively high in respect to other infrared system components with the costs for detector embodiment and the final assembly being a relevant part of total detector costs.

The construction of the multielement infrared detector device with high feed-through package density and low thermal loss will now be described in detail with reference to the attached figures by giving a concrete example of a particular technological version which illustrates the general concept.

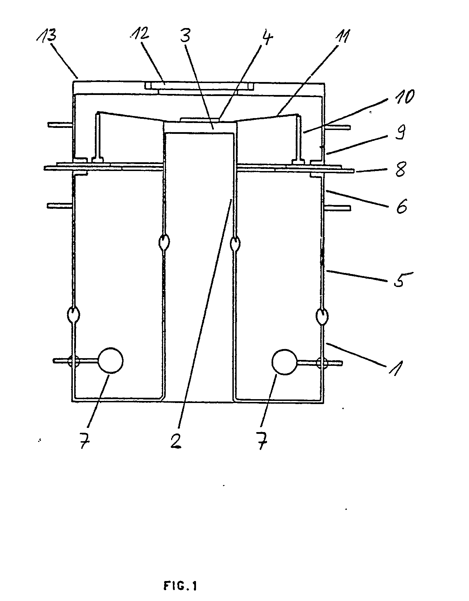

Fig. 1 shows schematically the cross section of the device comprising an infrared sensor array and a vacuum-cryocontainer. The device is a combination of several parts which have been ordered in respect to their specific functions regarding detector construction and detector operative features.

The detector body (Fig. 1) consists of a glass part 1 with an inner "cold finger" tube 2 which is made of glass or of glass/metal and which is closed by the disk-shaped part 3 serving as thermal contact between the cooling means within the cold finger and the photosensitive component 4 within the vacuum vessel. The part 1 is externally sealed to a metal tube 5 which itself is connected with the metal tube 6 being part of the multi-feed-through package, by means of brazing or welding.

In order to improve vacuum life time the absorption getters 7 are incorporated in the body 1.

The feed-through component is given by the elements 8 thru 11 of fig. 1.

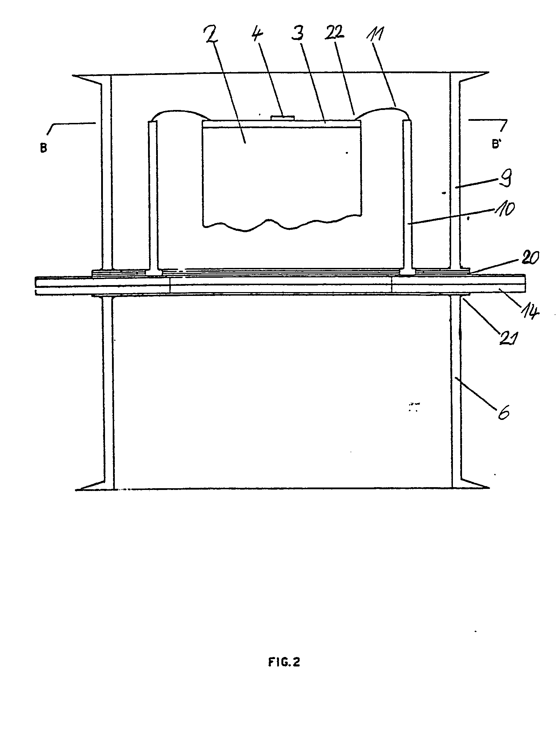

The element 8 comprises a ceramic substrate ring 14 (Fig. 2) with a metallization ring on the lower surface, and a pattern of radial metal strip-line tracks on the upper surface. A ceramic insulating layer is applied onto the centre part of the strip-line tracks which layer carries an upper metallization ring. This ring and the metallization ring on the lower surface of the substrate are connected with the metal tubes 9 and 6, respectively. Each metal strip-line track provides a metal pin 10 of a length such as to have a co-planar position of the pin head in respect to the photosensitive component 4. The interconnection between the photosensitive component which is mounted on the disk 3 and the feed-through pattern is performed by means of thin wires 11 of low thermal conductivity suited to commonly used micro-wire bonding techniques.

The component 12 of fig. 1 is an infrared transparent window, hermetically sealed to a metal ring 13 which provides an edge for the final closure of the detector embodiment by means of welding connection of the two elements 13 and 9.

Not shown on the fig. 1 is the tube for the evacuation process of the embodiment.

Fig. 2 shows a cross section of the particularity of the assembly of the vacuum feed-through component.

On fig. 3, the sector f gives a plane view of the assembly of fig. 2 with the two corresponding lines AA' (fig. 3) and BB' (fig. 2). The numbers of fig. 2 correspond to those of fig. 3.

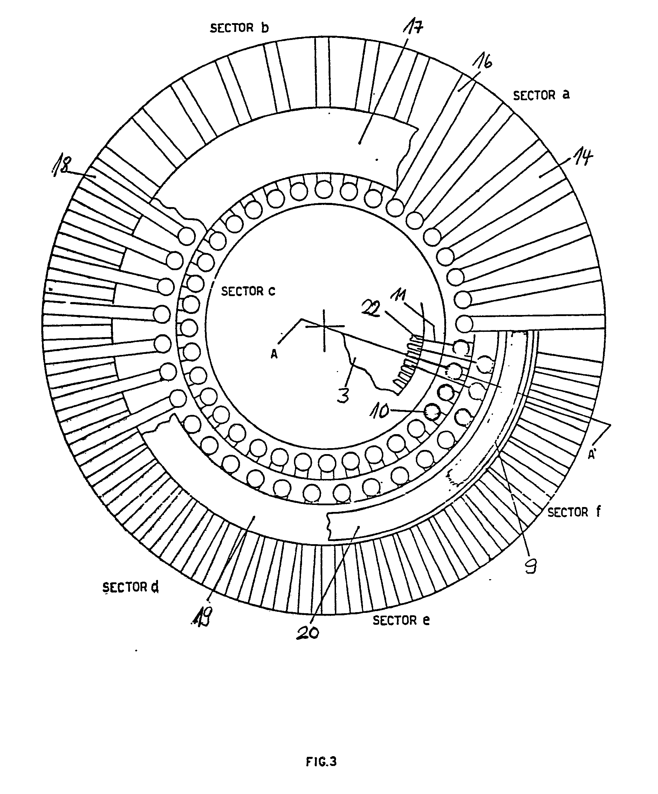

The ceramic substrate ring 14 (fig. 2 and fig. 3, section a) is alumina.

On this substrate 14 is applied a sequence of different metal and ceramic layers 16 thru 20 by means of screen printing. The screen print sequence is illustrated by the sectors a thru e of fig. 3. All the screen print processes present standard technological elements, well known to those skilled in the art of integrated circuit packages production.

The first layer 16 of fig. 3 is a pattern of metal strip lines, ending in, for instance circular, dots. Metals which are typically applied are moly-manganese or tungsten. The following layer 17 of fig. 3 is insulating alumina. A second metal strip line pattern is applied 18, fig. 3) with the dots being electrically isolated from the first metal pattern plane, as indicated on sector c of the figure. Onto the sector c plane another insulation layer of alumina is applied (19, fig. 3) followed by a metal layer 20, fig. 3. After having performed this multilayer configuration, a metallizating ring 21 similar to the layer 20 of fig. 3 is applied to the rear surface of the substrate 8 as indicated on fig. 2.

The complete multilayer structure is then sintered by a firing process at temperatures much higher than 1000°C. After this, all exposed metal surfaces are metal plated.

The detector assembly is going to be completed by a next step of feed-through component construction. The metal pins 10 of fig. 2 and 3, for instance made of iron cobalt nickel alloys as Kovar® or Vacon® are nail-head brazed on the metal dots which are the inner terminals of the strip lines 16 and 18 of fig. 3 by means of for instance alloy preforms.

Thereafter, the tubes 9 and 6 (fig. 2 and fig. 3) of for instance Kovar® or Vacon® are head brazed on the upper and rear metallizations (20 and 21, fig. 3). In case of using tungsten/nickel the brazing process with a preform of copper silver eutectic together with OFHC grade copper is an often used technique.

At this point, the multi-feed-through component is ready for being assembled on the body component of fig. 1, by connecting the elements 6 and 5 of fig. 1 for instance by means of arc welding.

On fig. 2 is shown the cold finger 2 with the infrared sensitive component 4 and its carrier substrate 3 on top mounted and on fig. 3 are sketched the terminals 22 of the conducting paths which connect the photosensitive elements or other elements of electronic preprocessing mounted on the cooled plane 3. The terminals 22 are connected with the flat shaped heads of the pins 10 by round or rolled wires 11 with diameters of, for instance, from 25 microns to 50 corresponding cross sections.

The wire material typically has such a low thermal conductivity as to reduce the thermal through-wire loss to a sufficiently low value even with lengths of only a few millimeters or anyway, with lengths, short enough to be compatible with the very compact detector structure which offers small distances between the on-focal plane substrate 3 of fig. 2 and 3 and the metal connector pins 10.

With wire alloys on the base of, for example, nickel crome or copper nickel which are standard materials known under various trademarks, thermal power losses are less than 10 mWatt/per 100 elements, values which are negligible in respect to the total thermal loss of the detector.

Even with such high thermal resistance of the interconnection wires, they are still electronically compatible regarding their electrical resistances with the output impedances of the infrared sensitive elements including such low impedances of about 50 Ohm in case of cadmium mercury telluride photoconductive mode sensors.

As it has been described before, the two planes of 22, fig. 2 fig. 3 and the flat shaped head of pin 10 are in co-planar position.

This configuration allows the use of standard, market available micro-bonding machines together with a high process automation suited to low cost production performed by unskilled personnel.

The choice of the bonding technique depends on the metal utilized for the elements 22, 11 and 10 of fig. 2 and 3. It is obvious, that there are many ways of electroplating or other means of metal deposition to match certain bonding requirements.

Just to give an example, if Kovar® (Vacon)® is used for both the wire 11 and the pin 10 together with a nickel or nickel-chrome finish on the terminal 22, the bonding process can be performed by means of Kovar gap-welding which is known as one of the most reliable interconnection techniques.

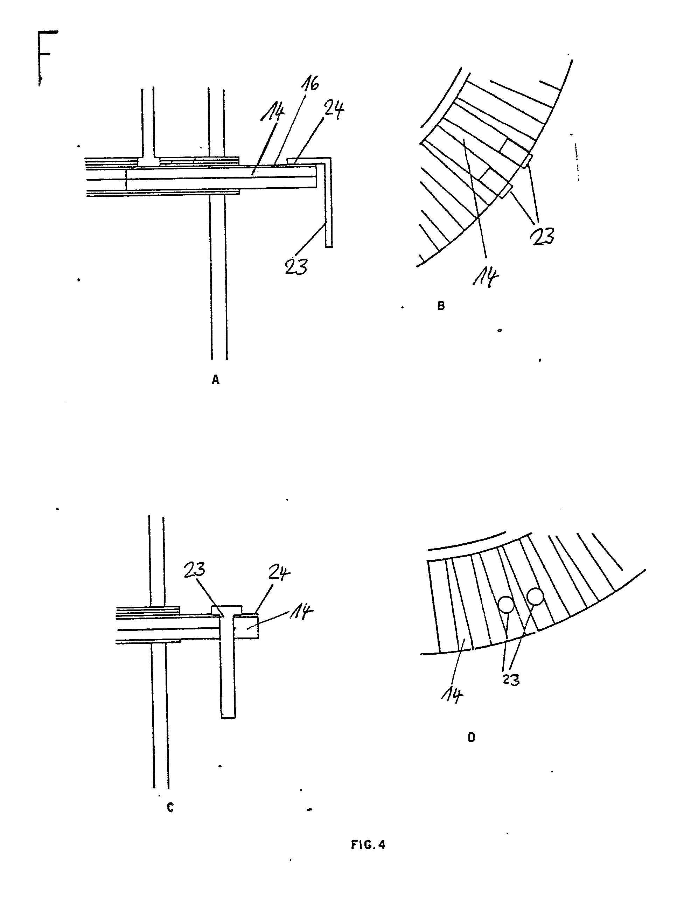

In order to facilitate external circuitry wiring connections the extending strip lines 16 of fig. 4 can be provided with metal pins or pads 23 which are brazed by means of an alloy 24 in the same way as the pin brazing process has been performed.

After having presented a concrete example of the device according to the invention and after having illustrated technological ways how to construct it, there will now be described the advantages deriving from the invention.

A first advantage of the described structure is the extremely high feed-through track pattern density. Using standard technological margins and tolerances, a strip-to-strip center pitch of less than 0.3 millimeters is easily achievable when using the double metal strip layer configuration of the above described example and further reductions are within the feasibility margins of the techniques of the state of the art.

We have performed experimental investigation on constructing and testing of the feed-through component which have shown up high fabrication yield and which have further demonstrated excellent vacuum tightness figures (real leaks) which by far satisfy the stringent requirements in applications for detectors with long vacuum life time expectance.

Furthermore, the basic design concept of the feedthrough component illustrated by the above concrete example is ideally suited to low cost mass production.

The multi-feed-through component, being a separatedly constructed module is 100 percent tested before the assembly with the other components of the device, according to the specifications of the particular detector for which it is used. This in-process check eliminates rejects caused by defects in the feed-through package, revealed in an advanced stage of detector assembly and presents therefore a further advantage.

Other advantages are given by the very low production costs and by the design flexibility due to low costs for tools and screen print layouts even in case of small-scale or of sample production.

Still another advantage lies in compactness and mechanical ruggedness of the described multilayer package together with the high reliability of the sintered metal strip pattern.

An advantage which has already been mentioned in the foregoing is given by the microwire bonding technique between pin 10 and focal plane connector terminal 22 on fig. 2 and 3. The type of bonding technique which results in high reliable contacts allows the use of standard, marked available bonding machines, high degree of process automation and low cost production with unskilled personal.

As it has been said in the foregoing, one of the fundamental requirements of multielement infrared detector devices is the necessity of low thermal loss.

Thermal loss due to thermal conduction is practically limited to the heat flux through the cold finger walls with values which are essentially dictated by the type of the cooler and its technical requirements. Losses due to thermal radiation are reduced in the usual way to a minimum by wall metallization and by means of incorporated metal layers with low emissivity values, high reflectivity and low transversal thermal conductivity. Thermal load due to the power dissipated by the infrared sensitive component or other electronic components depends on the type of the optoelectronic converter component and is therefore not taken into account here except of the fact of having provided a good thermal contact between the inner wall of the cold finger top and the on focal plane assembled photosensitive component by means of the disk 3 of fig. 2.

The high thermal conduction of the element 3 of fig. 1 together with the high thermal resistance between the infrared sensor component and the inner walls of the detector embodiment which resistance is mainly determined by radiation losses, reduces the temperature difference to very low values.

In the case of, for instance, indium antimonide sensor components operating in photoconductive mode, the detectivity performance often decreases with increasing temperatures in the range above 80 degrees Kelvin.

Therefore, if optoelectronic performance is temperature dependent the combination of the high conductance of element 3 of fig. 1 and the high resistance of wires 11 of fig. 2 and 3 gains an important aspect regarding system operative performances in particular, when the infrared system requires a large ambient temperature range. The very narrow zone in which the interconnection wires 11 of fig. 2 and 3 are localized favorizes the application of high efficient radiation screening.

Following the ideas presented in the foregoing, the lower limit of the outer diameter of the detector device is essentially determined by the diameter of the cold finger and hence by the type of the cooler which is a system requirement parameter. Considering for instance dimensions of Joule-Thompson minicoolers together with a feed-through package density of less than 0.3 mm/per strip line and a number of 100 feed-throughs, the outer diameter, including the extending strip line pattern ring illustrated by 1 of fig. 4, results less than 25 millimeters.

On the other hand, a number of 100 connector terminals on the centre substrate having a diameter given by the Joule-Thompson cooler, is at the upper limit of package density regarding microwire bonding techniques. From this it turns out, that for almost all applications the upper number of feed-throughs is practically unlimited and that upper number of photosensitive elements of the multielement device is limited by the area of the carrier substrate 3 of fig. 2 and 3 which is mounted on the focal plane.

When having mentioned the detector-type with integrated thermoelectric cooler (example 3) it is trivial to say to have to substitute the "cold finger" by a heat sink, externally connected with the vacuum embodiment.

**Claims**

1. Device for detecting infrared radiation comprising:

(a) an infrared detector consisting of an array of photosensitive elements (4) disposed on a carrier substrate (3) provided with a first pattern of strip line conductors (22) connected to and extending from said photosensitive elements (4),

(b) a cryostat having a vacuum chamber within which said carrier substrate is mounted at the top of a cold finger (2) opposite an infrared transparent window (12), the outer wall of said vacuum chamber comprising two parts (6, 9) joined along a path extending in a cross-sectional plane parallel to the mounting plane of said carrier substrate (3),

(c) a planar ring-shaped feed-through component (8) disposed in said cross-sectional plane in sealing relationship with said two parts and comprising a ceramic base member (14) carrying a second pattern of strip-line conductors (16, 18) extending partly outside and partly inside said vacuum chamber where they are connected to terminals of the conductors (22) of said first pattern by means of connecting wires (11), the device being characterised in that

(d) said second pattern of strip-line conductors (16, 18) comprises two groups of conductors, the conductors (16) of one group being directly disposed on the ceramic base member (14) and being partly covered by an insulating ceramic layer (17) extending over the conductors of said one group in respective intermediate sections thereof, whereas the conductors (18) of the other group are arranged, with part of their lengths, on said insulating layer (17), the remaining part of their lengths being arranged on said ceramic base member (14) within an area thereof extending outside the vacuum chamber and in interposed relationship with the uncovered sections at one end of the conductors of the first group.

2. Device as claimed in claim 1 with the conductors (16, 18) of said second pattern and said insulating ceramic layer (17) being implemented by means of screen print and high temperature sinter techniques.

3. Device as claimed in claim 2 comprising metal pins (10) which are brazed onto those ends of the conductors (16, 18) of said second pattern, which are disposed inside the vacuum chamber.

4. Device as claimed in claim 3 with said metal pins (10) consisting of a nickel-cobalt-iron alloy.

5. Device as claimed in claim 4 with the heads of said metal pins (10) being in co-planar position in respect to the plane of said strip line conductors (22) on said carrier substrate (3).

6. Device as claimed in any of claims 1 to 5 wherein the terminals of said first pattern and said metal pins (10) are connected by means of conventional micro-circuitry bonding techniques.

7. Device as claimed in claims 1 to 6 wherein said connecting wires (11) are thin wires of metal alloys having high thermal resistances.

8. Device as claimed in claims 1 or 2 wherein the upper and lower surfaces of said feed-through-component (8) are hermetically sealed with metal flanges of said parts (6, 9) of said outer wall.

9. Device as claimed in claim 8 with said metal flanges being made of a nickel-cobalt-iron alloy.

10. Device as claimed in any of claims 1, 8 or 9 wherein said metal flanges are also hermetically sealed to a base member of said vacuum chamber and to an upper flange member containing said infrared transparent window (12), respectively.

11. Device as claimed in claims 1 to 10 in which those parts of the conductors (16, 18) of the second pattern, which extend outside the vacuum chamber are connected with metal pins or pads by means of through-hole or L-shaped brazing.

12. Device as claimed in any of claims 1 to 11 in which said cryostat comprises a dewar.

13. Device as claimed in any of the preceding claims wherein the end of said cold finger (2) consists of a metal alloy.

14. Device as claimed in claim 13 wherein said metal alloy is a nickel-cobalt-iron alloy.

15. Device as claimed in any of claims 1 to 14 wherein absorption getters (7) are incorporated in said vacuum chamber.

**Patentansprüche**

1. Vorrichtung für das Erfassen von Infrarotstrahlung, mit

(a) einem Infrarotdetektor, der aus einer Mehrfachanordnung von fotoempfindlichen Elementen (4) besteht, die auf einem Schichtträger (3) angeordnet sind, welcher ein erstes Muster von Streifenleitern (22) aufweist, die mit den fotoempfindlichen Elementen (4) verbunden sind und sich von diesen wegerstrecken,

(b) einem Kryostaten mit einer Vakuum-Kammer, in der der Schichtträger auf der Spitze eines Kaltfingers (2) befestigt ist, welcher gegenüber einem für Infrarotlich durchlässigen Fenster (12) angeordnet ist, wobei die Außenwand der Vakuum-Kammer zwei Teile (6, 9) aufweist, die entlang eines Weges verbunden sind, der sich in einer Schnittebene parallel zu der Befestigungsebene des Schichtträgers (3) erstreckt,

(c) einem ebenen ringförmigen Durchleitungsbauteil (8), das in der Schnittebene gegenüber den beiden Teilen abdichtend angeordnet ist und ein keramisches Basiselement (14) aufweist, welches ein zweites Muster von Streifenleitern (16, 18) trägt, die sich teils außerhalb und teils innerhalb der Vakuum-Kammer erstrecken, in der sie mit Anschlüssen der Streifenleiter (22) des ersten Musters mittels von Verbindungsdrähten (11) verbunden sind, dadurch gekennzeichnet,

(d) daß das zweite Muster von Streifenleitern (16, 18) zwei Gruppen von Streifenleitern aufweist, von denen die eine Gruppe von Streifenleitern (16) unmittelbar auf dem keramischen Basiselement (14) angebracht ist und teilweise mit einer isolierenden Keramikschicht (17) bedeckt ist, die sich über die eine Gruppe von Streifenleitern je in Zwischenabschnitten erstreckt, während die andere Gruppe von Streifenleitern (18) mit Teilen ihrer Längenabschnitte auf der isolierenden Keramikschicht (17) angeordnet sind und die verbleibenden Teile ihrer Längenabschnitte auf dem keramischen Basiselement (14) in einen Bereich angeordnet sind, der sich außerhalb der Vakuum-Kammer erstreckt, so daß sie sich an einem Ende je zwischen den unbedeckten Bereichen der ersten Gruppe von Streifenleitern befinden.

2. Vorrichtung nach Anspruch 1, dadurch gekennzeichnet, daß die Streifenleiter (16, 18) des zweiten Musters und die isolierende Keramikschicht (17) durch Siebdruck und Hochtemperatur-Sinterverfahren hergestellt sind.

3. Vorrichtung nach Anspruch 2, dadurch gekennzeichnet, daß Metallstifte (10) vorgesehen sind, die auf den Enden der Streifenleiter (16, 18) des zweiten Musters aufgelötet sind, die sich innerhalb der Vakuum-Kammer befinden.

4. Vorrichtung nach Anspruch 3, dadurch gekennzeichnet, daß die Metallstifte (10) aus einer Nickel-Kobalt-Eisen-Legierung bestehen.

5. Vorrichtung nach Anspruch 4, dadurch gekennzeichnet, daß die Köpfe der Metallstifte (10) in der Ebene der Streifenleiter (22) auf dem Schichtträger (3) liegen.

6. Vorrichtung nach einem der Ansprüche 1 bis 5, dadurch gekennzeichnet, daß die Anschlüsse des ersten Musters und die Metallstifte (10) mittels üblicher Bond-Verfahren aus der Mikroschaltkreistechnik verbunden sind.

7. Vorrichtung nach einem der Ansprüche 1 bis 6, dadurch gekennzeichnet, daß die Verbindungsdrähte (11) dünne Drähte aus Metallegierungen mit hohem Wärmewiderstand sind.

8. Vorrichtung nach einem der Ansprüche 1 oder 2, dadurch gekennzeichnet, daß die oberen und unteren Flächen der Durchführungsbauteile (8) hermetisch mit Metallflanschen der Teile (6, 9) der Außenwand verbunden sind.

9. Vorrichtung nach Anspruch 8, dadurch gekennzeichnet, daß die Metallflansche aus einer Nickel-Kobalt-Eisen-Legierung hergestellt sind.

10. Vorrichtung nach einem der Ansprüche 1, 8 oder 9, dadurch gekennzeichnet, daß die Metallflansche ebenfalls hermetisch zu einem Basiselement der Vakuum-Kammer bzw. zu einem oberen Flanschelement abgedichtet sind, das das für Infrarotlicht durchlässige Fenster (12) aufweist.

11. Vorrichtung nach einem der Ansprüche 1 bis 10, dadurch gekennzeichnet, daß die Teile der Streifenleiter (16, 18) des zweiten Musters, die sich außerhalb der Vakuum-Kammer erstrecken, mit Metallstiften oder -ansätzen mit Hilfe von Durchtrittsloch- oder L-Form-Löten verbunden sind.

12. Vorrichtung nach einem der Ansprüche 1 bis 11, dadurch gekennzeichnet, daß der Kryostat ein Dewarsches Gefäß aufweist.

13. Vorrichtung nach einem der vorhergehenden Ansprüche, dadurch gekennzeichnet, daß das Ende des Kaltfingers (2) aus einer Metallegierung besteht.

14. Vorrichtung nach Anspruch 13, dadurch gekennzeichnet, daß die Metallegierung eine Nickel-Kobalt-Eisen-Legierung ist.

15. Vorrichtung nach einem der Ansprüche 1 bis 14, dadurch gekennzeichnet, daß Absorptions-Getter (7) in der Vakuum-Kammer eingebaut sind.

**Revendications**

1. Dispositif pour détecter un rayonnement infrarouge, comportant:

(a) un détecteur infrarouge constitué par un réseau d'éléments photosensibles (4) disposés sur un substrat de support (3) muni d'un premier ensemble de conducteurs en forme de bandes (22), raccordés auxdits éléments photosensibles (4) et s'étendant à partir de ces derniers,

(b) un cryostat comportant une enceinte à vide à l'intérieur de laquelle ledit substrat de support est monté sur l'extrémité supérieure d'un doigt froid (2) situé en vis-à-vis d'une fenêtre (12) transparente au rayonnement infrarouge, la paroi extérieure de ladite enceinte à vide comportant deux parties (6, 9) réunies le long d'un trajet s'étendant dans un plan de coupe parallèle au plan de montage dudit substrat de support (3),

(c) un composant de traversée en forme d'anneau plat (8), disposé dans ledit plan de coupe transversale en étant relié de façon étanche auxdites deux parties et comportant un organe de base en céramique (14) portant un second ensemble de conducteurs en forme de bandes (16, 18) s'étendant partiellement à l'extérieur et partiellement à l'intérieur de ladite enceinte à vide, où ils sont raccordés à des bornes des conducteurs (22) dudit premier ensemble à l'aide de fils de raccordement (11), le dispositif étant caractérisé en ce que

(d) ledit second ensemble de conducteurs en forme de bandes (16, 18) comporte deux groupes de conducteurs, les conducteurs (16) d'un premier groupe étant disposés directement sur l'organe de base en céramique (14) et étant recouverts partiellement par une couche de céramique isolante (17) s'étendant par-dessus les conducteurs dudit premier groupe dans des sections intermédiaires respectives de ces derniers, tandis que les conducteurs (18) du second groupe sont disposés, sur une partie de leurs longueurs, sur ladite couche isolante (17), la partie restante de leurs longueurs étant située sur ledit organe de base en céramique (14) à l'intérieur d'une zone de ce dernier s'étendant à l'extérieur de l'enceinte à vide et ce d'une manière interposée avec les sections non recouvertes situées au niveau d'une extrémité des conducteurs du premier groupe.

2. Dispositif selon la revendication 1, dans lequel les conducteurs (16, 18) dudit second ensemble et ladite couche céramique isolante (17) sont réalisés à l'aide de la technique de la sérigraphie et d'une technique de frittage à haute température.

3. Dispositif selon la revendication 2, comportant des broches métalliques (10) qui sont brasées sur les extrémités des conducteurs (16, 18) dudit second ensemble, qui sont disposées à l'intérieur de l'enceinte à vide.

4. Dispositif selon la revendication 3, dans lequel lesdites tiges métalliques (10) sont constituées par un alliage de nickel-cobalt-fer.

5. Dispositif selon la revendication 4, dans lequel les têtes desdites tiges métalliques (10) sont situées dans le même plan que lesdits conducteurs en forme de bandes (22) sur ledit substrat de support (3).

6. Dispositif selon l'une quelconque des revendications 1 à 5, dans lequel les bornes dudit premier ensemble et lesdites tiges métalliques (10) sont raccordées au moyen de techniques classiques de liaison de microcircuits.

7. Dispositif selon les revendications 1 à 6, dans lequel lesdits fils de raccordement (11) sont des fils minces d'alliages métalliques possédant des résistances thermiques élevées.

8. Dispositif selon la revendication 1 ou 2, dans lequel les surfaces supérieure et inférieure dudit composant de traversée (8) sont scellées hermétiquement à l'aide de brides métalliques desdites parties (6, 9) de ladite paroi extérieure.

9. Dispositif selon la revendication 8, dans lequel lesdites brides métalliques sont constituées par un alliage de nickel-cobalt-fer.

10. Dispositif selon l'une quelconque des revendications 1, 8 ou 9, dans lequel lesdites brides métalliques sont également scellées de façon hermétique respectivement à un organe de base de ladite enceinte à vide et à un organe formant bride supérieure contenant ladite fenêtre (12) transparente pour le rayonnement infrarouge.

11. Dispositif selon les revendications 1 à 10, dans lequel les parties des conducteurs (16, 18) du second ensemble, qui s'étendent à l'extérieur de l'enceinte à vide, sont raccordées à des tiges métalliques ou à des plots de connexion au moyen d'un trou traversant ou d'une brasure en forme de L.

12. Dispositif selon l'une quelconque des revendications 1 à 11, dans lequel ledit cryostat comporte un vase de Dewar.

13. Dispositif selon l'une quelconque des revendications précédentes, dans lequel l'extrémite dudit doigt froid (2) est constitué par un alliage métallique.

14. Dispositif selon la revendication 13, dans lequel ledit alliage métallique est un alliage de nickel-cobalt-fer.

15. Dispositif selon l'une quelconque des revendications 1 à 14, dans lequel des getters absorbants sont insérés dans ladite enceinte à vide.

FIG.1

FIG.2

SECTOR b

SECTOR a

SECTOR c

SECTOR f

SECTOR d

SECTOR e

A

A'

FIG.3

F

16

14

24

23

A

B

14

23

14

23

24

14

C

D

FIG. 4

4